# EUROPEAN PATENT APPLICATION

(11) **EP 4 465 781 A1**
(43) Date of publication of application: **20.11.2024**
(21) Application number: 23460017.9
(22) Date of filing: 19.05.2023
(51) Int. Cl.: H05K 7/20

(54) **ELECTRONIC DEVICE AND METHOD OF COOLING THEREOF**

(71) Applicant: TRUMPF Huettinger Sp. Z o. o., 05-220 Zielonka (PL)
(72) Inventor: The designation of the inventor has not yet been filed
(74) Representative: Trumpf Patentabteilung

(57) **Abstract**

An electronic device (10), in particular a high power (HP), high voltage (HV) pulsed power supply for biasing a substrate in a plasma process, said electronic device (10) comprising:
- a plurality of electrical components (15) capable to generate heat when the device (10) is in use,
- a container (12), wherein at least a part of said plurality of electrical components (15) are placed,
- an electrically insolating heat transfer liquid (13), filled within said container (12) and having direct contact to the electrical components (15) to transport heat away from those electrical components (15) and to enhance the electrical insolation between those electrical components in comparison to the electrical insolation of air, the liquid (13) being enclosed in the container, so that it has no contact with extraneous gas outside the container, and the liquid has been degassed before the start of operation.

## Description

The invention relates to an electronic device comprising a plurality of electrical components generating heat, in particular a high power (HP) pulsed power supply for plasma processing, said electronic device comprising:
- a container, wherein said plurality of electrical components are placed,
- an electrical insolating heat transfer liquid, filled within said container and having direct contact to the electrical components to transport heat away from those electrical components and to enhance the electrical insolation between those electrical components in comparison to the electrical insolation of air.

HP pulsed power supplies are often needed in plasma process equipment, e.g. for biasing a substrate, as disclosed in US 10,474,184 B2, e.g.. For such a plasma process equipment, often one or more power supplies are needed, which may comprise such aforementioned electronic device. Such a power supply and such an electronic device is known from European patent application with the application number 22461514.6, filed on 28.02.2022 with the title: "High Power Generator and Method of Supplying High Power Pulses", e.g. which is hereby incorporated by reference in its entirety, and hereinafter referred to as: 'EP22461514.6'.

For this invention, high power (HP) shall mean 2 kW or more, especially 10 kW or more, of power during at least some of the pulse-on-times. High voltage (HV) shall mean voltages of 1 kV or more, especially 5 kV and more, in particular 10 kV or more, during at least some of the pulse-on-times. Pulsed power supply shall mean a power supply with a pulsing frequency being in the range of 50 Hz up to 800 kHz.

In such a HP, HV pulsed power supply the following challenges arise: For several reasons of a wanted behavior of the plasma process, the power supply should often be arranged as near as possible to the plasma process. Otherwise too much energy losses occur in the feed cable, and the feed cable costs arise. Further the voltage and/or the current rise slope could be negatively affected, e.g., due to dielectric losses within the cable. Because there is only little space available nearby the plasma chamber, the overall dimensions for such a power supply are very limited. To keep the dimensions as small as possible, electronical parts must be packed close together in the power supply.

However, these small dimension requirements are contradictory to the high insolation requirements caused by the high voltages and to the low capacitance requirements in the power supply due to the high rising times of voltage and current.

The 'electrical insolating heat transfer liquid' should be electrically nonconducting in a reliable way. The insulating characteristics should be better than air. With 'air' is meant all kinds of air around in a typical environment of such an electronic device during manufacture, maintenance, tests and/or use. With such an electrically insolating liquid, lower creepage distances and/or lower discharge distances are possible than they are when air is used for insulation.

Possible liquids that may be used for cooling are disclosed in WO2021/008949 A1, e.g., where there are described fluorinated liquids which are very effective heat transfer liquids.

It was found however that in such power supplies with direct contact cooling with said described liquids it comes to unforeseeable and random failures. Those failures where the point of research and investigation.

In view of this, it is the object of the invention to disclose an improved electronic device and an improved method of cooling an electronic device reducing the problems mentioned above. In particular, an improved electronic device that is suitable with the high power (HP) and high voltage (HV) pulsed power supply for plasma processing, shall be disclosed. The overall dimensions should be kept as small as possible, however without any drawbacks to reliability.

Also, a method of cooling such a device shall be disclosed.

With respect to the device, this object is fulfilled by an electrically insolating heat transfer liquid being enclosed in the container so that it has no contact with extraneous gas outside the container in operation of the electronic device, and the electrically insolating heat transfer liquid has been degassed before the start of operation.

With being 'degassed before the start of operation' is meant the removal of dissolved gases from the liquid. There are numerous methods for removing dissolved gases from liquids, such as pressure reduction, thermal regulation, membrane degasification, ultrasonic degassing, sparging by inert gas, addition of reductant, etc..

It was found that the unforeseeable and random failures had a reason in the formation of bubbles in the liquid when the liquid heats up during operation of the electronic device. With a decrease of this bubble formation, the frequency of occurrence of such failures could be reduced. So, numerous attempts where made to reduce this formation of bubbles. One successful attempt was the degassing of the liquid and the prevention of solving of new gas during delivery, installation and/or operation.

In one aspect the degassing of said liquid is done while manufacturing the electronic device before delivery and before use of it. So, the manufacturer has full control of the degassing process and may control the condition of the device before delivery and installation. Different conditions for different applications or environments such as ambient temperature are possible to save costs in production.

In one aspect the electronic device is configured so that the degassing of the liquid may be done during maintenance and/or use of the electronic device. For such a purpose an inlet and outlet for the liquid may be attached to the container. These connections may be closable and sealable, so no gas or air from outside may come into the container during the degassing procedure.

In one aspect the electronic device comprises a degassing unit for removing gas from said liquid. With such a degassing unit connected to the container, the degassing may take place also during operation. This might be an extra benefit in process areas where the requirements on reliability of the electronic device are very high or the temperature and/or voltages between the components are very high.

In one aspect said degassing unit comprises a housing having a liquid inlet, a liquid outlet, at least one porous membrane, and at least one gas outlet. Such a degassing unit could be helpful in degasification during operation and/or maintenance.

In one aspect said degassing unit comprises a membrane including a plurality of pores for removing gas from said liquid. Such a degassing unit could be helpful in degasification during operation and/or maintenance and/or manufacture.

In one aspect said degassing unit comprises a low pressure, in particular a vacuum source connected to said at least one gas outlet. With such a degassing unit gas could be removed in a very efficient way.

In one aspect said degassing unit comprises a hollow fiber membrane array comprising a plurality of hollow fiber membranes arranged coaxially within a cartridge, a distribution tube, and a collecting tube between which a baffle is arranged for diverting liquid. With such a degassing unit gas could be removed in a very efficient way.

In one aspect said electrically insolating heat transfer liquid is enclosed in a hermetically closed volume, this hermetically closed volume is arranged at least partly inside the container and kept in a predetermined regulated pressure area.

In one aspect the container comprises:
- a first volume filled with gas, and
- a second volume filled with the electrically insolating heat transfer liquid without a separating part between the first and the second volume.

No membrane between first volume and the second volume is needed here. This is possible especially when the electrically insolating heat transfer liquid has a solubility of the gas in the first volume high enough to compensate for the volume change of the second volume with the temperature in a predefined temperature range which is the range of temperature during use of the device.

In one aspect the container comprises:
- a first volume filled with gas, and
- a second volume filled with the electrically insolating heat transfer liquid, and
- a membrane separating the first volume from the second volume.

In one aspect the membrane is permeable for gas in the direction from the second volume to the first volume but not in the opposite direction.

In one aspect the device comprises a pressure control, in particular a gas pressure control, to control the pressure in one or more of the following volumes:
- the first volume,
- the second volume, and
- the hermetical closed volume.

In one aspect the electronic device comprises a liquid guiding equipment, configured to guide the electrically insolating heat transfer liquid along at least a part of the plurality of electrical components in parallel, so that said part of the plurality of electrical components are cooled with the same temperature. This has the big advantage in such an electronic device that electrical deviations in said part of the plurality of electrical components resulting from temperature differences between said components could be reduced. This leads to a much more stable electronic device.

There could be different solutions of liquid guiding equipment, like tubes, pumps, ventilators and so on. The important thing is that those solutions are able to guide the liquid in parallel across those electrical components to cool them with the same temperature.

In one aspect the electronic device is configured in that
a. the plurality of electrical components comprises semiconductor components, in particular transistors and/or diodes, connected in a series circuit, this series circuit configured to be connected to a high voltage ≥ 1 kV when in operation, where
b. the semiconductor components, in particular transistors and/or diodes, in the series circuit are connected in such a way that, in operation, the high voltage is divided between at least a part of said semiconductor components, and
c. the electronic device comprises a liquid guiding equipment, configured to guide the electrically insolating heat transfer liquid along at least a part of those semiconductor components in parallel, so that those semiconductor components are cooled with the same temperature.

It has been found that in such an electronic device, in particular in an aforementioned high power, high voltage pulsed power supply the need of a series connection of several switching elements exists. This switching element must switch so fast for the pulsed power supply that only semiconductor components are a possible solution. Transistors operated in a switch-mode, are a good possibility for those semiconductor components.

But such transistors are limited in maximum voltage across their connections and are often not suitable for voltages ≥ 1 kV. One possible solution is to connect those semiconductor components, in particular transistors, in such a way that, in operation, the high voltage is divided between at least a part of said semiconductor components. But this does only work, when that circuit is balanced good enough, so that the voltage at any of those semiconductor components does not rise above the limited value of that semiconductor component. Such a balancing is a difficult topic in design. Even small deviations could lead to an unbalance which is perhaps at the beginning small but increases with self-enhancing feedback. It was found that even the cooling equipment has an influence on the balancing. After research, it was recognized that the cooling of the components in a parallel way, with the approach to cool the components with the same temperature, has an improving influence of the overall balancing of those components.

So, it was decided to find a structure, which comprises a liquid guiding equipment, configured to guide the electrically insolating heat transfer liquid along at least a part of those semiconductor components in parallel, so that these semiconductor components are cooled with the same temperature.

As mentioned before, there could be different solutions of liquid guiding equipment, like tubes, pumps, ventilators and so on. The important thing is that those solutions are able to guide the liquid in parallel across those electrical components to cool them with the same temperature.

In one aspect the liquid guiding equipment comprises several culverts in a PCB in a predetermined distance from said semiconductor components which are placed on the PCB in a way to be cooled with the same temperature.

With PCB is meant a printed circuit board on which the electrical components may be placed and connected or similar carrier for the electrical components.

In one aspect, said transistors are operated as switching transistors to switch the pulses for the high voltage (HV) pulsed power supply. Examples and functionality are described in more detail in 'EP22461514.6', e.g..

In one aspect the liquid guiding equipment is made of a volume with a first pressure on one side of a PCB or carrier for electrical components and a volume with a second pressure on the other side of a PCB or carrier for electrical components and the PCB or carrier for electrical components comprises holes as culverts to guide the liquid in parallel.

In one aspect the device comprises components having contact with said liquid and being configured for moving, in particular fan wings or pump rotors, where at least some of those components are made from metal or other conductive materials or are coated by a layer of conductive material, in particular titanium nitrate.

In one aspect the device comprises a fluctuation generator configured for moving the liquid around said container for transferring heat from said electrical components.

In one aspect at least some of said electrical components are arranged so that electrical potentials of said electrical components support natural convection acting as the fluctuation generator.

In one aspect said fluctuation generator comprises a stirrer or a pump.

In one aspect said liquid is configured as a liquid filled into said container, and in that said container comprises a first volume above a liquid level of said liquid.

Moreover, with respect to the method, the object of the invention is achieved by a method of cooling an electronic device, in particular a HP pulsed power supply for biasing a substrate in a plasma process, said method comprising the steps of:
- providing a container,
- arranging electrical components generating heat when used within said container,
- filling an electrical insolating heat transfer liquid into said container,
- removing gas from said liquid,
- circulating said liquid, in particular around said container, for transferring heat from said electrical components,
- preventing gas from being dissolved in the liquid.

It was found that some failures may be caused by gas bubbles in the liquid which develop during heat up of the liquid. So, it was found that the proposed usage of such insolating liquids in a gas/liquid equilibrium as proposed by WO 2021/008949 A1 can affect the usage of such a power supply adversely.

The invention solves the problem to build a high HP, HV pulsed power supply for biasing a substrate in a plasma process. It works highly reliable with the plasma process.

According to a further embodiment of the invention, any insolating components having contact with the liquid and being configured for moving, such as fan wings or pump rotors, are made from metal or other conductive materials, or are coated by a layer of conductive material. Thereby, the amount of electrostatic discharges is reduced and thereby the efficiency of the components that come into contact with the insolating cooling liquid is enhanced by reducing electrostatic forces in the liquid.

According to a further embodiment of the invention, at least some of the electrical components are arranged so that electrical potentials of the electrical components support natural convection acting as a fluctuation generator. In view of this, a dedicated pump unit can be avoided or arranged in a smaller form. Since insolating liquids are sensitive to high gradient of electric field and can be accelerated using strong electric fields, this phenomenon can be used for moving the liquid. Usually, liquids are accelerated from the negative potential of an electric field in a direction to the positive potential. This phenomenon can be used to obtain a natural convection. To obtain natural convection, preferably the direction of electric potentials should be designed properly. Thus, mechanical pumps, fans or stirrers can be either fully avoided or the effectiveness of such devices can be enhanced by also using natural convection.

According to a further embodiment of the invention, the fluctuation generator comprises a stirrer or a pump. In view of this, a highly effective gas removal can be obtained.

According to a further embodiment of the invention, the liquid is configured as a liquid filled into the container, and the container comprises a free gas volume above a liquid level of the liquid. It was found that gas solubility of cooling liquids depends on the pressure. Since liquids expand with rising temperature, some extra empty volume should be provided to allow for the volume expansion of the cooling liquid. If the pressure increases, also the gas solubility increases. Thus, more gas is dissolved with rising pressure. Consequently, the pressure decreases and stabilizes on the level where the gas solubility is highest for a given pressure. So, the total volume of the container of the cooling liquid and the gas can be kept as small as possible.

According to a further embodiment of the invention, the degassing unit comprises a membrane including a plurality of pores for removing gas from the liquid. Using a membrane is very effective in removing gas from a flowing liquid. The pores are usually micropores small enough so that only gas and no liquid is removed.

According to a further embodiment of the invention, the effectiveness of the gas removal can be further enhanced by using a vacuum source that is connected to the at least one gas outlet.

According to a further embodiment of the invention, the degassing unit comprises a hollow fiber membrane array comprising a plurality of hollow fiber membranes arranged coaxially within a cartridge, a distribution tube and a collecting tube between which a baffle is arranged for diverting liquid.

Such a degassing unit is sold under the trademark "Liqui-Cel" by 3M. Such a degassing unit is dedicated for removing gases from water. According to the invention such a commercial degassing unit is used for removing gas from an electrical insolating heat transfer liquid.

According to a further embodiment of the method of the invention, the liquid is circulated by natural convection, preferably assisted by electrical fields generated by at least some of the electrical components.

According to a further embodiment of the method, the liquid is circulated by a pump or stirrer.

According to a further embodiment of the invention, the gas is removed from the liquid using a porous membrane.

Moreover, the gas removal may be assisted by a vacuum to enhance effectiveness.

Also, the electrical insolating heat transfer liquid may be configured as a liquid which is filled into the container with a free volume extending above a top level of the liquid.

All these measures help to improve the effectiveness of the method according to the invention.

It may be understood that the features mentioned above and to be mentioned hereinafter cannot only be used in the given combination but also in different combinations or independently from each other without leaving the scope of the invention.

Further features and advantages of the invention will become obvious from reading the subsequent description of preferred embodiments in combination with the accompanying drawings.
- Fig. 1A: shows a first embodiment of an electronic device;
- Fig. 1B: shows a further embodiment of an electronic device;
- Fig. 1C: shows a further embodiment of an electronic device;
- Fig. 2: a chart showing the trend of the pressure inside the container with cooling liquid and the gas above a free gas volume and the trend of the temperature of the cooling liquid over the elapsed time;
- Figs. 3: a perspective partially sectioned representation of a conventional degassing unit in schematic representation used for the current invention;
- Fig. 4: shows a further embodiment of an electronic device;
- Fig. 5: shows a further embodiment of an electronic device;
- Fig. 6: shows a further embodiment of an electronic device;
- Fig. 7: shows an embodiment of a series circuit to be connected to a high voltage; and

Fig. 8 shows a plasma processing system with a plasma chamber.

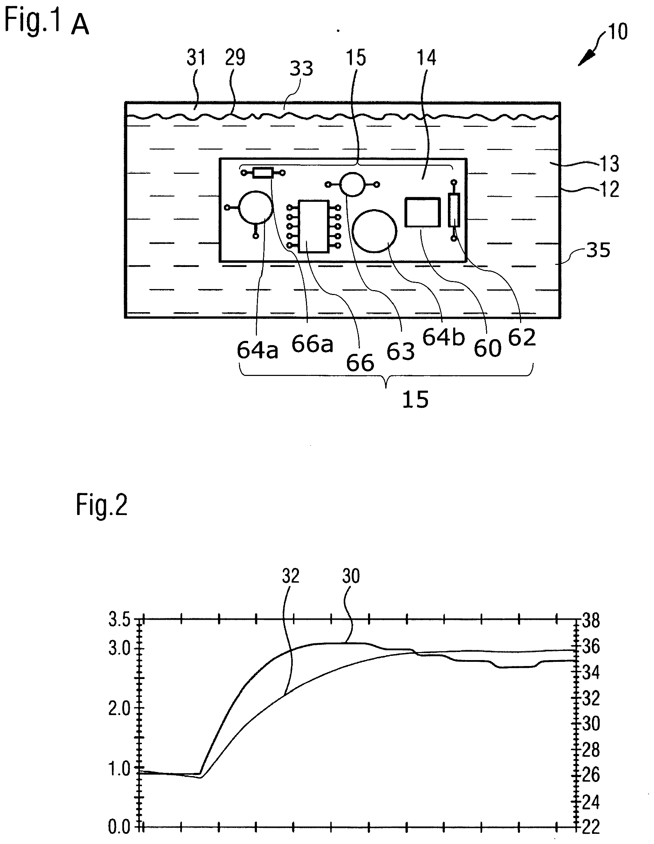

In Fig. 1A, an embodiment of an electronic device 10 according to the invention is shown in a schematic representation.

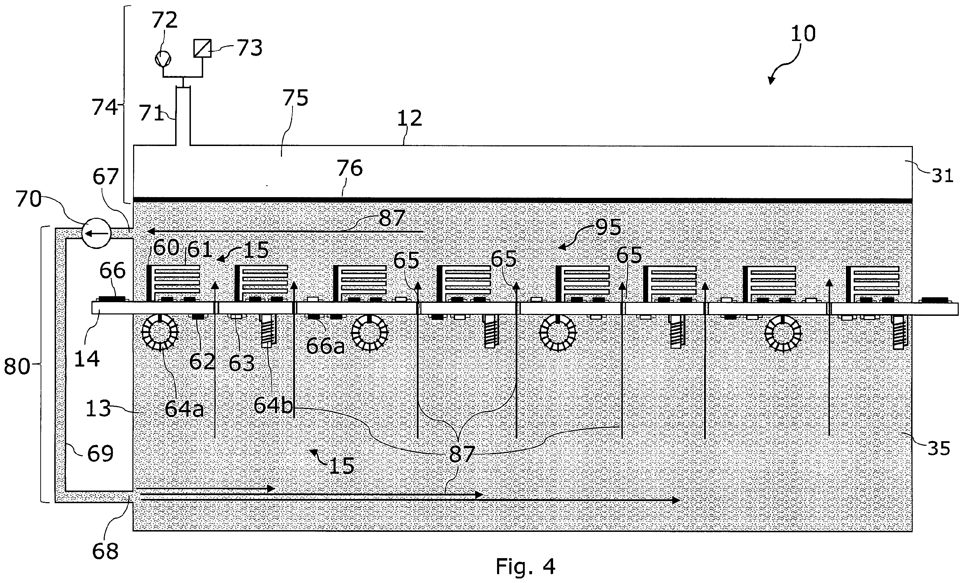

The device 10 comprises a printed circuit board (PCB) 14 or a comparable carrier of electric or electronical components 15. A variety of electric or electronical components 15 are positioned on the PCB 14. Those electric or electronical components 15 could be one or several transistors 60, diodes 66a, one or several resistors 62, one or several capacitors 63, one or several inductors and/or transformers 64a, 64b, or one or more integrated circuits 66, in particular semiconductor based, such as driver circuits for the transistors 60. They are all part of the electronic device 10. In this embodiment the whole PCB 14 and all electronical components 15 are positioned inside the container 12. This is not obligatory. It is here and in all other embodiments possible, but also possible, that some of the parts 15 are outside the container 12, as it is shown later in Fig. 4-6.

A container 12 is filled with a liquid 13. The liquid 13 is configured as an insolating heat transfer liquid, e.g., such as disclosed by WO 2021/008949 A1 which is herewith fully incorporated by reference in its entirety.

The electronic device 10 may be any kind of electronic device that requires a high packaging density and requires direct liquid cooling. In particular, the device 10 may be a HP, HV pulsed power supply, in particular for biasing a substrate in a plasma process, such as known from the EP22461514.6.

The electronic device 10 may be a part of a HP, HV pulsed power supply, in particular for biasing a substrate in a plasma process, in particular that part of such a power supply which needs cooling and insolation the most, such as: switching transistors, HV transformers, diodes, and damping circuits comprising inductivities and/or resistors, e.g..

The container 12 may be hermetically closed, so, no gas or liquid may leave. Gas solubility of cooling liquids may be controlled by the pressure of the liquid 13. The liquid extends with rising temperature. Thus, some extra volume 31 filled with a compressible medium such as gas above the top level 29 of the liquid 13 is required to allow the increase of second volume 35 of the liquid 13.

If the ratio of volume of the liquid 13 and the first volume 31 of the compressible medium and the pressure at a predefined temperature is chosen in a preferred way, then the following happens: If the pressure increases, also the gas solubility increases. Therefore, more gas is dissolved by the liquid 13. Consequently, the pressure in the container decreases and stabilizes on the level where the gas solubility is highest for the present pressure.

In Fig. 2, the trend of the pressure inside the container 12 with the cooling liquid 13 in the gas volume 31 on top is shown by pressure line 30, and the trend of the temperature of the cooling liquid over the time is shown by temperature line 32. Both lines 30, 32 are lines over time, so the horizontal axis is a time axis. On the right axis a scale for the values of temperature is shown in °C. On the left axis a scale of values of differential pressure is shown. The numbers are to be multiplied by a factor of 0,1 bar.

The phenomenon may be explained in the following with the help of the graph of Fig. 2: A cooling liquid 13 with a high solubility of gas may be used to reduce the container 12 volume and to compensate for the volume change with the temperature. On the other hand, the volume of the container 12 with the cooling liquid 13 and the gas shall be kept as small as possible to avoid a thermal extension of the liquid 13.

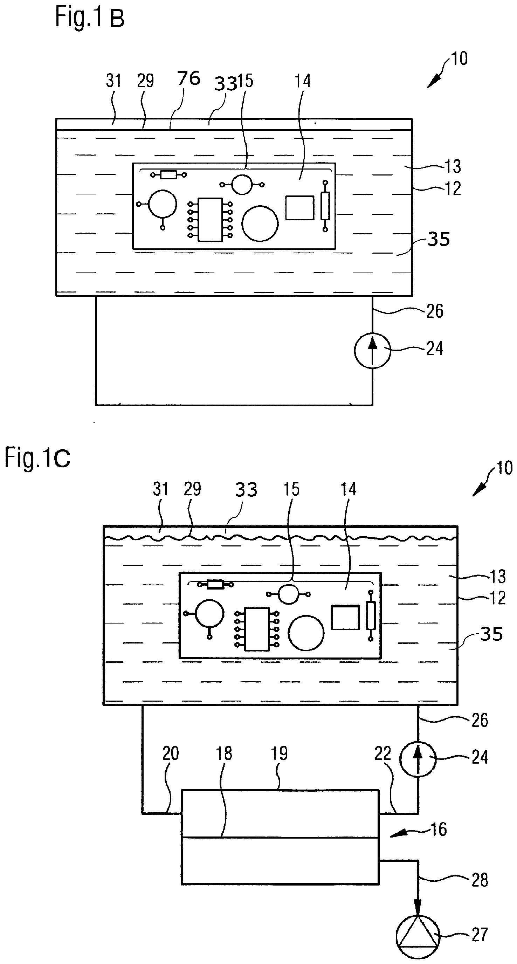

Fig. 1B shows a further embodiment of an electronic device 10. In comparison to the device 10 in Fig. 1A, a fluctuation generator 24, especially a pump is connected to the container 12. From the fluctuation generator 24 the liquid is fed back into the container 12 through a liquid line 26.

In comparison to the device 10 in Fig. 1A there is a membrane 76 between the first volume 31 and the second volume 35. This is here not obligatory; it is just shown here to demonstrate the combination possibilities of the features mentioned above.

Fig. 1C shows a further embodiment of an electronic device 10. In comparison to the device 10 in Fig. 1A, a fluctuation generator 24, and a degassing unit 16 is used for removing gas from the liquid 13 in pouring coolant over the device. In the shown device, the degassing unit 16 is arranged externally for high effectiveness and easy access. After degassing liquid 13, the degassing unit 16 can be disconnected as shown in figs. 1A, 1B or remains inactive.

The degassing unit 16 comprises a housing 19 within which a porous membrane 18 is arranged. Liquid 13 from the container 12 is drawn to an inlet port 20 of the degassing unit and exerts through an outlet port forced by a fluctuation generator 24, especially a pump. By the porous membrane 18 gas is removed and exerts through a gas outlet port. The gas removal is usually assisted by an external vacuum source 27.

Container 12 is filled with liquid 13 so that a small volume of free gas 31 remains above the liquid. The element separating the free gas from the liquid is membrane 76.

The membrane 76 is used to separate the coolant from the gas and prevents free gas 31 from entering the degassed liquid 13. Such a design leads to a highly effective gas removal from the liquid 13.

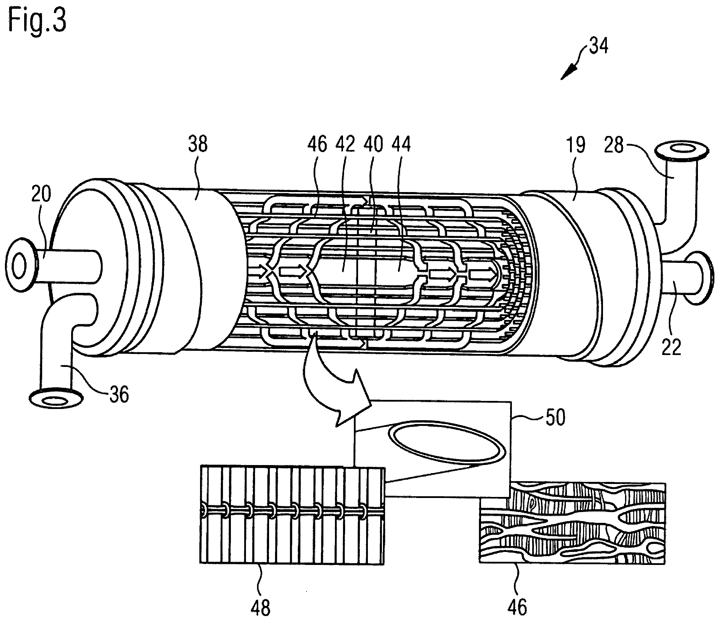

In Fig. 3, a suitable highly effective degassing unit is shown that is marketed by 3M under the trademark "Liqui-CEL" and designated in total with reference numeral 34. This degassing unit is dedicated for removing gases from water, but according to the invention, is used for removing gases from the electrically insolating heat transfer liquid 13.

In the following description of Fig. 3, the same reference numerals as before are used for similar parts.

The degassing unit 34 comprises a housing 19 within which a cartridge 38 is included. At a first end of the housing 19 there is provided a liquid inlet port 20; at the second end there is provided an outlet port 22.

At the first end there is further arranged a gas/vacuum port 36 and at the second end there is arranged a gas outlet port 28. From the inlet port 20, the liquid travels through a central distribution tube 42 and is distributed in radial direction to enter into a hollow fiber membrane array 48 consisting of a plurality of hollow fiber membranes 46 that are arranged coaxially within the cartridge 38.

There is a central baffle 40 for deflection to the outside so as to improve the effectiveness. On the other side of the baffle 40, there is a central collection tube 44 for collecting the liquid after the gas removal that exerts the degassing unit 34 through the outlet port 22.

A portion of a hollow fiber membrane is shown enlarged and depicted by 46. An enlarged micropore within the membrane 46 is shown by reference numeral 50. The fiber membrane array is shown enlarged by the cutout 48.

Fig. 4, Fig. 5, and Fig. 6 show three different embodiments of an electronic device 10. The electronic device 10 comprises a container 12. This container 12 comprises a heat transfer liquid 13, a PCB 14, a circulating device 80, and a pneumatic system 74.

The container 12 is filled with heat transfer liquid 13. The PCB 14 is arranged in the container 12 and surrounded by the heat transfer liquid 13. Further, the PCB 14 is led out of the container 12 on two sides.

The PCB 14 is equipped with various components. These components include transistors 60, heat sinks 61, resistors 62, capacitances 63, inductors 64a, 64b, diodes 66a, and drivers 66. The drivers 66 of the PCB 14 could be arranged outside the container 12 on the PCB 14. In this way they are thus not surrounded by the heat transfer liquid 13. The remaining components are arranged inside the container 12 on the PCB 14 and are thus surrounded by the heat transfer liquid 13. The inductors 64a, 64b are shown in two different embodiments. The heat sinks 61 are each arranged on the transistors 60 and have a plurality of pins. The PCB 14 further comprises several culverts 65. These culverts 65 are designed to allow the heat transfer liquid 13 to flow through. As a result, the heat transfer liquid 13 can flow through the PCB 14, so that above and below the PCB 14 is the same heat transfer liquid 13. For reasons of clarity, only one of the different components are provided with a reference mark. However, the remaining components can also be assigned via the same appearance of the same components.

The electronic device 10 comprises a liquid guiding equipment 95, configured to guide the electrically insolating heat transfer liquid 13 along at least a part of the plurality of electrical components 15, so that said part of the plurality of electrical components 15 are cooled with the same temperature.

As mentioned before, there could be different solutions of liquid guiding equipment 95, like tubes, pumps, ventilators and so on. The important thing is that those solutions are able to guide the liquid in parallel across those electrical components to cool them with the same temperature.

One possible solution is the liquid guiding equipment is made of a volume with a first pressure on one side of a PCB 14 and a volume with a second pressure on the other side of a PCB 14 and the PCB comprises holes as culverts 65 to guide the liquid in parallel.

The components described and illustrated here are exemplary for the assembly of PCB 14. The PCB 14 may also be equipped with other components, such as diodes 66a.

The circulating device 80 of the container 12 comprises a heat transfer liquid outlet 67, a heat transfer liquid inlet 68, a heat transfer liquid pump 70 and a heat transfer liquid conduit 69. When the heat transfer liquid 13 heats up, the heated heat transfer liquid rises inside the container 12 upwards. Via the heat transfer liquid outlet 67, the heat transfer liquid 13 that has risen upwards can then reach the circulating device 80, in which it can get back into the lower area of the container 12 through the heat transfer liquid pump 70, the heat transfer liquid conduit 69 and the heat transfer liquid inlet 68. Within the circulating device 80, the heat transfer liquid 13 can be cooled down by other devices. Overall, the circulating device 80 thus ensures circulation of the heat transfer liquid 13 within the container 12.

As shown with the arrows 87 the heat transfer liquid 13 flows through the culverts 65 to cool several components also the transistors 60 in parallel, so that they are cooled with the same temperature.

As the heat transfer liquid 13 heats up, it expands and the pressure in the container 12 thus increases. The container 12 has a pneumatic system 74 to counteract this pressure increase. The purpose of this pneumatic system 74 is to regulate the pressure within the container 12.

For this purpose, the pneumatic system 74 in Fig. 4 comprises a membrane 76, a gas 75, a pumping device 72 and a gas pressure control 73. The membrane 76 has an elastic material and is arranged above the PCB 14 in container 12. The membrane 76 is impermeable to the heat transfer liquid 13. For gas 75, the membrane 76 may be permeable from one side, namely from bottom to top. The gas 75 of the pneumatic system 74 is located in container 12 above the membrane 76. Due to the one-sided gas permeability of the membrane 76, unwanted gas in the heat transfer liquid 13 can pass through the membrane 76 out of the heat transfer liquid 13. As a result, the heat transfer liquid 13 can be less influenced in its function.

When the heat transfer liquid 13 expands, the membrane 76 is pushed upwards and with no change in the volume of the gas 75 in the container 12, the pressure in the container 12 increases. However, via the pumping device 72 and the gas pressure control 73, the volume of the gas 75 in container 12 can be increased or reduced. The pumping device 72 and gas pressure control 73 are connected to the container 12 via the gas outlet 71.

Overall, the pneumatic system 74 can therefore increase or reduce the pressure in container 12 by increasing or reducing the volume of the gas 75 in container 12.

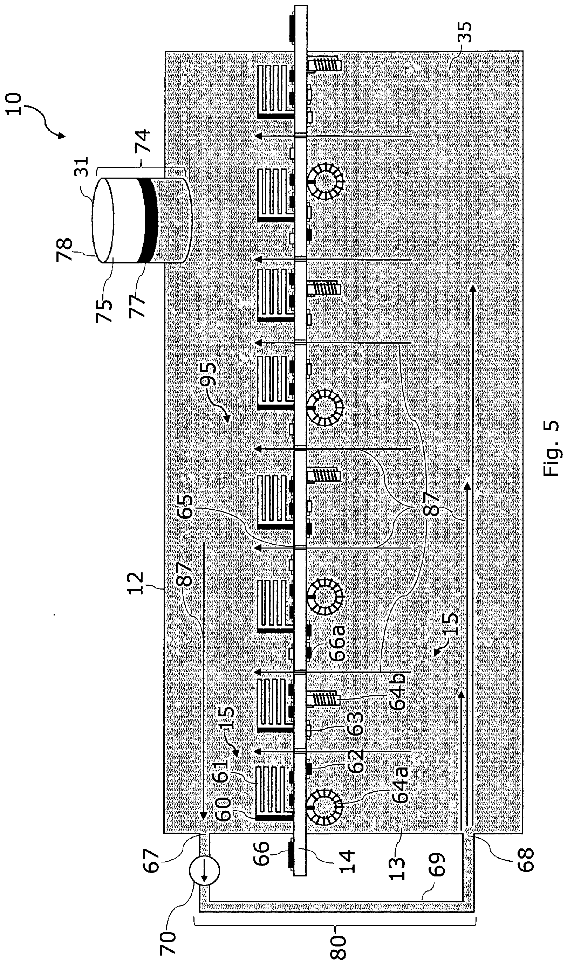

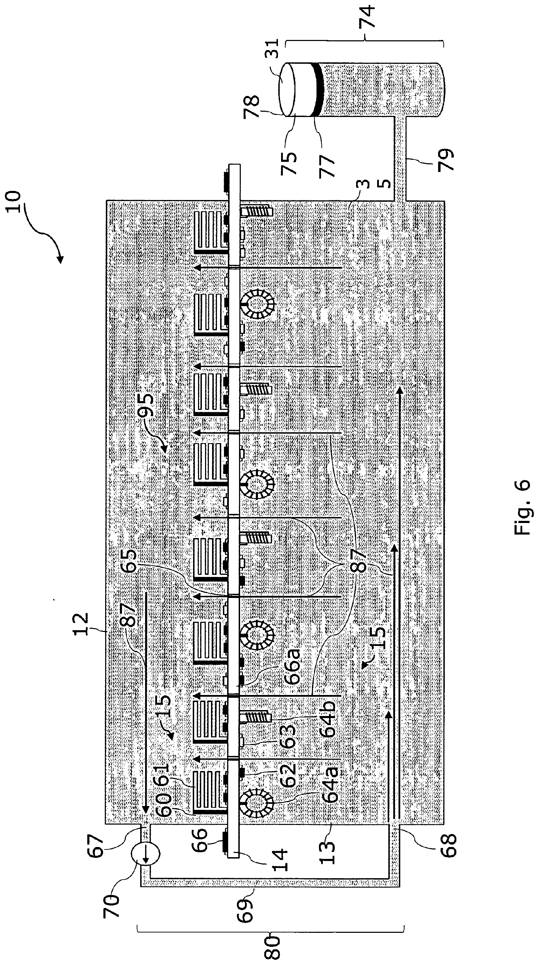

In Fig. 5 and Fig. 6, the pneumatic system 74 has a cylinder 78, a piston 77, gas 75, a pumping device 72 (not shown), and a gas pressure control 73 (not shown).

Basically, the pneumatic system 74 has here the same function and also functionality as the pneumatic system 74 from Fig. 4.

The only difference is that the pneumatic system 74 is designed in the form of a cylinder 78. The gas 75 of the pneumatic system 74 via which the pressure in the container 12 is regulated, is arranged within the cylinder 78, above the piston 77 and is not located in the container 12. The piston 77 assumes the function of the membrane 76 and can be moved up and down via the volume of gas 75 located in the cylinder 78 in order to change the pressure in the container 12. The pumping device 72 and the gas pressure control 73 may be located at the top of the cylinder 78 (not shown).

In Fig. 5, this cylinder 78 is introduced into the container 12. Thus, the heat transfer liquid 13 of the container 12 can enter the cylinder 78 via an open underside of the cylinder 78.

In Fig. 6, the cylinder 78 is arranged outside the container 12 and connected via a cylinder conduit 79 to the container 12. Via the cylinder conduit 79, the heat transfer liquid 13 of the container 12 can enter the cylinder 78. The cylinders 78 may have the same material as the container 12.

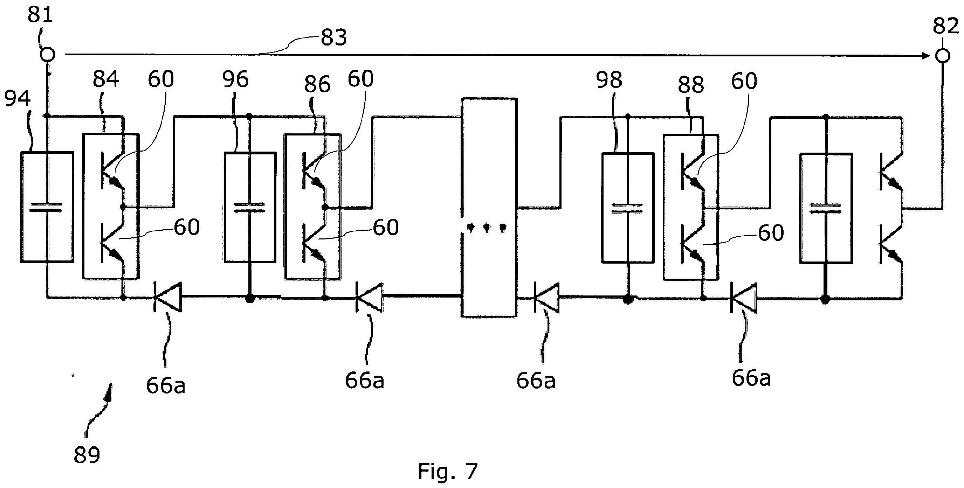

Fig. 7 shows an embodiment of a series circuit 89 configured to be connected to a high voltage 83, HV ≥ 1 kV when in operation. This HV 83 between the connection points 81 and 82 may be established by a plurality of low-power generators (LP-generators) 94, 96, 98, connected in series.

The series circuit 89 comprise semiconductor components 84, in particular transistors 60 and/or diodes 66a, each connected in series.

Further details and functions of such a circuit are explained in EP22461514.6. The embodiment of a series circuit 89 shown in Fig. 7 is only one of several possible embodiments. Some further embodiments are described in EP22461514.6, e.g..

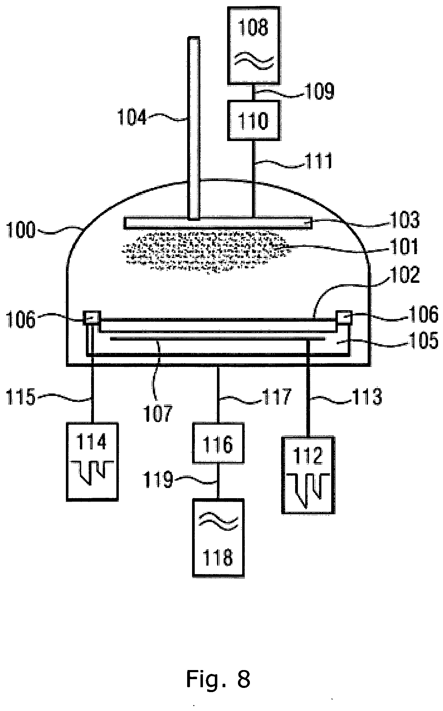

Fig. 8 shows a plasma processing system with a plasma chamber 100 in which a plasma 101 is established in a plasma space. Such or similar systems are shown and described also in EP22461514.6, e.g.. For such or a similar system the device 10 of this description is designed. In the plasma chamber an upper electrode 103 may be positioned. A gas inlet and/or outlet, in particular a gas supply pipe 104 may be placed from the outside to the inside of the plasma chamber 100, in particular connected to the electrode 103. A substrate 102, in particular a semiconductor wafer may be placed on a support 105 which comprises a substrate holder inside the plasma chamber 100. In use the substrate 102 may be processed by the plasma 101, e.g., in a process of etching, ashing, or deposition in particular with atomic layered deposition. Etching process may be an extremely high challenge, for instance when the ratio between etched hole diameter and hole length is extremely low, < 1/100, e.g., as it is in deep etching often necessary. An electric conductive electrode 106 may be placed in the plasma chamber 100, in particular nearby the substrate 102, for example around the substrate 102. This electric conductive electrode 106 may be an edge ring which may be also called focus ring. This electric conductive electrode 106 may be connected to a first power supply 114 via a first connection line 115. The first power supply 114 may be a DC pulsed power supply, where in particular the pulses may be of different length, different amplitude and shaped as described in US 10,474,184 B2, Fig. 2 e.g..

With the control of the first power supply 114 the electric conductive electrode 106 may be used additionally or alternatively as an ion energy and/or ion acceleration direction control as also described in US 10,474,184 B2. A first radio-frequency (RF) power supply 118 may be electrically connected to the support 105 via a first power feeding rod 119 and a first matching unit 116 and a first connection unit 117. A second radio-frequency (RF) power supply 108 may be electrically connected to the upper electrode 103 via a second power feeding rod 109 and a second matching unit 110 and a second connection unit 111. An electrode 107 may be positioned in or nearby the support 105 and is electrically connected to a second power supply 112 via a second connection line 113. The second power supply 112 may be a DC pulsed power supply, where in particular the pulses may be of different length, different amplitude and shaped as described in US 10,474,184 B2, Fig. 2, e.g.. The substrate 102 may be fixed at the support 105 via the electrode 107 which may work as an electrostatic chuck. With the control of the second power supply 112, the electrode 107 may be used additionally or alternatively as an ion energy and/or ion acceleration direction control as described in US 10,474,184 B2.

Some plasma treatment applications, such as etching or layer deposition, demand a high voltage (HV), high frequency (HF), rectangular, asymmetrical, pulsed voltage supply. Often the voltage values significantly exceed the voltage handling possibilities of individual semiconductor switches, especially when high frequency operation is required.

Some plasma applications require not only pulsing, but pulse-to-pulse amplitude variation. Some plasma applications require the source to deliver high peak currents in order to obtain short voltage transition times. Most plasma applications present a load, which contains a capacitive component.

Significant power loss is related to the pulse-by-pulse charging and discharging process of this load capacitance. Some plasma applications require pulse shaping as described in US 10,474,184 B2, Fig. 2, e.g..

All described power supplies 104, 112, 114, 118 may comprise an electronic device 10 as described in this patent application.

For the HV, a series connection of such switches is one possible solution. Series connection requires voltage balancing means. These voltage balancing means are not easily realizable, especially in RF operation. Even smart changes in the series connection may follow to unbalances which are often self-enhancing and further deteriorate the system. It was found that even a cooling system which cools the series connection of switches in series and not in parallel might have such an impact.

## Claims

1. An electronic device (10), in particular a high power (HP), high voltage (HV) pulsed power supply for biasing a substrate in a plasma process, said electronic device (10) comprising:
- a plurality of electrical components (15) capable to generate heat when the device (10) is in use,
- a container (12), wherein at least a part of said plurality of electrical components (15) are placed,
- an electrically insolating heat transfer liquid (13), filled within said container (12) and having direct contact to the electrical components (15) to transport heat away from these electrical components (15) and to enhance the electrical insolation between these electrical components (15) in comparison to the electrical insolation of air,
**characterized by**
- the electrically insolating heat transfer liquid (13) being enclosed in the container (12) so that it has no contact with extraneous gas outside the container (12), in operation of the electronic device and the electrically insolating heat transfer liquid (13) has been degassed before the start of operation.

2. The device of the preceding claim, **characterized in that** the degassing of said liquid (13) is done while manufacturing the electronic device (13) before delivery and before use of it and/or the electronic device (10) is configured **in that** the degassing of the liquid (13) may be done during maintenance and/or use of the electronic device (10).

3. The device of any of the preceding claims, **characterized in that** the electronic device (10) further comprises a degassing unit (16, 34) for removing gas from said liquid (13).

4. The device of any of the preceding claims, **characterized in that** said electrically insolating heat transfer liquid (13) being enclosed in a hermetical closed volume (17), this hermetical closed volume (17) is arranged at least partly inside the container (12) and kept in a predetermined regulated pressure area.

5. The device of any of the preceding claims, **characterized in that** the container (12) comprises:
- a first volume (31) filled with gas, and
- a second volume (35) filled with the electrically insolating heat transfer liquid (13) without a separating part between the first and the second volume.

6. The device of any of the preceding claims, **characterized in that** the electrically insolating heat transfer liquid (13) has a solubility of the gas in the first volume (31) high enough to compensate for the volume change of the second volume (35) with the temperature in a predefined temperature range which is the range of temperature during use of the device (10).

7. The device of any of the preceding claims, **characterized in that** the container (12) comprises:
- a first volume (31) filled with gas, and
- a second volume (35) filled with the electrically insolating heat transfer liquid (13), and
- a membrane (76) separating the first volume (31) from the second volume (35).

8. The device of any of the preceding claims, **characterized in that** the membrane (76) is permeable for gas in the direction from the second volume (35) to the first volume (31) but not in the opposite direction.

9. The device of any of the preceding claims, **characterized in that** the device (10) comprises a pressure control, in particular a gas pressure control (73), to control the pressure in one or more of the following volumes:
- the first volume (31),
- the second volume (35), and/or
- the hermetical closed volume (17).

10. The device of any of the preceding claims, **characterized in that**
a. the electronic device (10) comprises a liquid guiding equipment (95), configured to guide the electrically insolating heat transfer liquid (13) along at least a part of the plurality of electrical components (15), so that said part of the plurality of electrical components (15) are cooled with the same temperature.

11. The device of any of the preceding claims, **characterized in that**
a. the plurality of electrical components (15) comprises semiconductor components (84, 86, 88), in particular transistors (60) and/or diodes (66a), connected in a series circuit (89), this series circuit (89) configured to be connected to a high voltage ≥ 1 kV when in operation, where
b. the semiconductor components (84, 86, 88), in particular transistors (60) and/or diodes (66a), in the series circuit (89) are connected in such a way that, in operation, the high voltage is divided between at least a part of said semiconductor components (84, 86, 88), and
c. the electronic device (10) comprises a liquid guiding equipment (95), configured to guide the electrically insolating heat transfer liquid (13) along at least a part of those semiconductor components (84, 86, 88) in parallel, so that those semiconductor components (84, 86, 88) are cooled with the same temperature.

12. The device of any of the preceding claims, **characterized in that** the liquid guiding equipment (95) comprises several culverts (65) in a PCB (14) in a predetermined distance from said semiconductor components which are placed on the PCB (14) in a way to be cooled with the same temperature.

13. The device of any of the preceding claims, **characterized in that** the device (10) comprises components having contact with said liquid (13) and being configured for moving, in particular fan wings or pump rotors, where at least some of those components are made from metal or other conductive materials, or are coated by a layer of conductive material, in particular titanium nitrate.

14. The device of any of the preceding claims, **characterized in that** said liquid (13) is configured as a liquid filled into said container (12), and **in that** said container (12) comprises a free gas volume (31) above a liquid level (29) of said liquid.

15. A method of cooling an electronic device (10) comprising a plurality of electrical components (15) generating heat, in particular a high power (HP) pulsed power supply for biasing a substrate in a plasma process, said method comprising the steps of:
- providing a container (12),
- arranging said electrical components (15) within said container (12),
- filling an electrically insolating heat transfer liquid (13) into said container (12),
- removing gas from said liquid (13),
- circulating said liquid (13), in particular around said container (12), for transferring heat from said electrical components (15)
- preventing gas from being dissolved in the liquid (13).
